# FASCICULE DE BREVET EUROPEEN

(11) **EP 0 817 150 B1**
(45) Date de publication et mention de la délivrance du brevet: **12.09.2001**
(21) Numéro de dépôt: 97401378.1
(22) Date de dépôt: 17.06.1997
(51) Int. Cl.: G08C 19/28, H05K 1/00

(54) **Procédé pour permettre le codage d'accord d'un dispositif de transmission avec un autre, et dispositif de transmission, tel qu'émetteur ou récepteur, correspondant**
Verfahren zum Ermöglichen der Übereinstimmungskodierung einer Übertragungsvorrichtung mit einer anderen und entsprechende Übertragungsvorrichtung, wie Sender oder Empfänger
Process for allowing agreement encoding of a transmission apparatus with another one, and corresponding transmission apparatus, such as a transmitter or receiver

(30) Priorité: 24.06.1996 FR 9607814
(43) Date de publication de la demande: 07.01.1998
(73) Titulaire: ARNOULD Fabrique d'Appareillage Electrique, 38160 Saint-Marcellin (FR)
(72) Inventeur: Sester, Jean-Marie, 38480 Saint Bonnet De Chavagne (FR)
(74) Mandataire: CABINET BONNET-THIRION

(56) Documents cités:
- DE-A- 2 941 394
- DE-A- 3 447 130
- US-A- 4 592 606
- US-A- 4 985 808
- US-A- 5 112 230
- US-A- 5 359 168

## Description

La présente invention concerne d'une manière générale les dispositifs de transmission du type de ceux mis en oeuvre par exemple pour la commande à distance de quelconques appareils électriques, et, notamment, de quelconques appareils d'éclairage.

Il s'agit aussi bien du récepteur qui pilote un tel appareil électrique que de l'émetteur mis à la disposition de l'usager pour la commande de celui-ci.

Il importe, bien entendu, que le récepteur et l'émetteur soient appariés l'un à l'autre, ou, autrement dit, qu'ils soient convenablement accordés.

Cela implique tout d'abord, qu'ils soient de même nature, et, par exemple, s'ils communiquent entre eux par ondes radio électriques, qu'ils travaillent l'un et l'autre à la même fréquence.

Mais, pour éviter d'éventuelles interférences avec d'autres dispositifs de transmission de même type disposés dans le voisinage, leur appariement implique, également, qu'ils utilisent tous les deux un même télégramme de communication, c'est-à-dire un même code.

Pour le codage d'accord ainsi nécessaire entre un récepteur et un émetteur, il est prévu, dans certains cas, de pouvoir appliquer au récepteur une opération d'apprentissage au cours de laquelle il prend en compte et mémorise le code de l'émetteur.

Mais cela nécessite que ce récepteur et cet émetteur soient dûment équipés des composants propres à une telle opération d'apprentissage, ce qui en renchérit inévitablement le coût.

Dans d'autres cas, plus traditionnels, l'émetteur et le récepteur sont simplement chacun individuellement équipés d'un commutateur particulier, fréquemment appelé roue codeuse, permettant d'y afficher à la demande un même code.

Mais, outre qu'il alourdit lui aussi inévitablement le coût des dispositifs de transmission qu'il équipe, ce commutateur a également pour inconvénient d'en accroître l'encombrement, ce qui peut être une gêne pour leur implantation dans un environnement mesuré.

Susceptible d'être affecté, le codage d'accord assuré manque de surcroît de fiabilité.

La présente invention a d'une manière générale pour objet une disposition permettant de s'affranchir de manière très simple de ces inconvénients.

De manière plus précise, elle a tout d'abord pour objet un procédé pour permettre le codage d'accord d'un dispositif de transmission avec un autre, ce procédé étant caractérisé d'une manière générale en ce qu'il consiste à prévoir, à la disposition de l'usager, dans ce dispositif de transmission, au moins un trajet conducteur sécable dont dépend le code auquel répond ce dispositif de transmission ; elle a encore pour objet tout dispositif de transmission, tel qu'émetteur ou récepteur, qui, en application d'un tel procédé, comporte, à la disposition de l'usager, au moins un trajet conducteur sécable dont dépend le code auquel il répond.

Lorsque, par exemple, pour le support et la desserte de quelconques composants, il est mis en oeuvre, dans un tel dispositif de transmission, une plaquette de circuit imprimé porteuse d'au moins une piste conductrice, il est avantageusement possible, suivant l'invention, de choisir pour trajet conducteur sécable un tronçon de cette piste conductrice, en faisant s'étendre, au moins localement, pour ce faire, cette piste conductrice sur une portion sécable de la plaquette de circuit imprimé.

En effet, la rupture de cette portion sécable de la plaquette de circuit imprimé entraîne inévitablement celle de la piste conductrice qu'elle porte.

Préférentiellement, plusieurs trajets conducteurs sécables distincts sont ainsi prévus à la disposition de l'usager.

La rupture de l'un et/ou de l'autre de ces trajets conducteurs sécables conduit par construction à un changement de code, et, par combinaison, le nombre de codes ainsi possibles est supérieur à celui des trajets conducteurs sécables disponibles.

Lorsqu'un codage d'accord s'avère nécessaire pour apparier un récepteur à un émetteur, il suffit donc de sectionner, à l'identique, sur chacun d'eux, tel ou tel de ces trajets conducteurs sécables.

Un outil simple peut avantageusement suffire à cet effet, tel que, par exemple, une pince coupante, une paire de ciseaux, un couteau, ou une simple lame tranchante du type de celle communément appelée "cutter".

Grâce au codage d'accord ainsi pratiqué, qui est avantageusement particulièrement fiable, la disposition suivant l'invention permet la cohabitation sans interférence d'installations très voisines, même lorsque ces installations sont toutes conjointement situées dans le champ de portée de l'émetteur de l'une quelconque d'entre elles.

Il est ainsi avantageusement possible d'envisager de ne prévoir économiquement à la fabrication qu'un même code pour l'ensemble des émetteurs et récepteurs en cause, seule résultant, si nécessaire, de la rupture d'un ou plusieurs trajets conducteurs sécables suivant l'invention, l'altération individuelle de ce code permettant l'accord strict d'un récepteur à un émetteur sans risque d'une commande intempestive de ce récepteur par un autre émetteur intervenant à proximité.

Outre qu'elle conduit à une réduction sensible de l'encombrement individuel de chacun des dispositifs de transmission en cause, la disposition suivant l'invention permet également avantageusement une réduction notable de leur coût.

Les caractéristiques et avantages de l'invention ressortiront d'ailleurs de la description qui va suivre, à titre d'exemple, en référence aux dessins schématiques annexés sur lesquels :
la figure 1 est, avec un arrachement local, une vue en perspective d'un dispositif de transmission suivant l'invention ;
la figure 2 reprend, à échelle supérieure, le détail de la figure 1 repéré par un encart II sur cette figure 1 ;
la figure 3 est, à échelle supérieure, une vue partielle en coupe transversale de ce dispositif de transmission, suivant la ligne III-III de la figure 1 ;
la figure 4 est, à échelle différente, et suivant la flèche IV de la figure 1, une vue partielle en plan de la plaquette de circuit imprimé dont est équipé ce dispositif de transmission, avant rupture de l'une quelconque des portions sécables que comporte cette plaquette de circuit imprimé ;
la figure 5 est une vue partielle du schéma représentatif de ce dispositif de transmission ;
la figure 6 est une vue partielle en plan analogue à celle de la figure 4, après la rupture d'une des portions sécables prévues suivant l'invention.

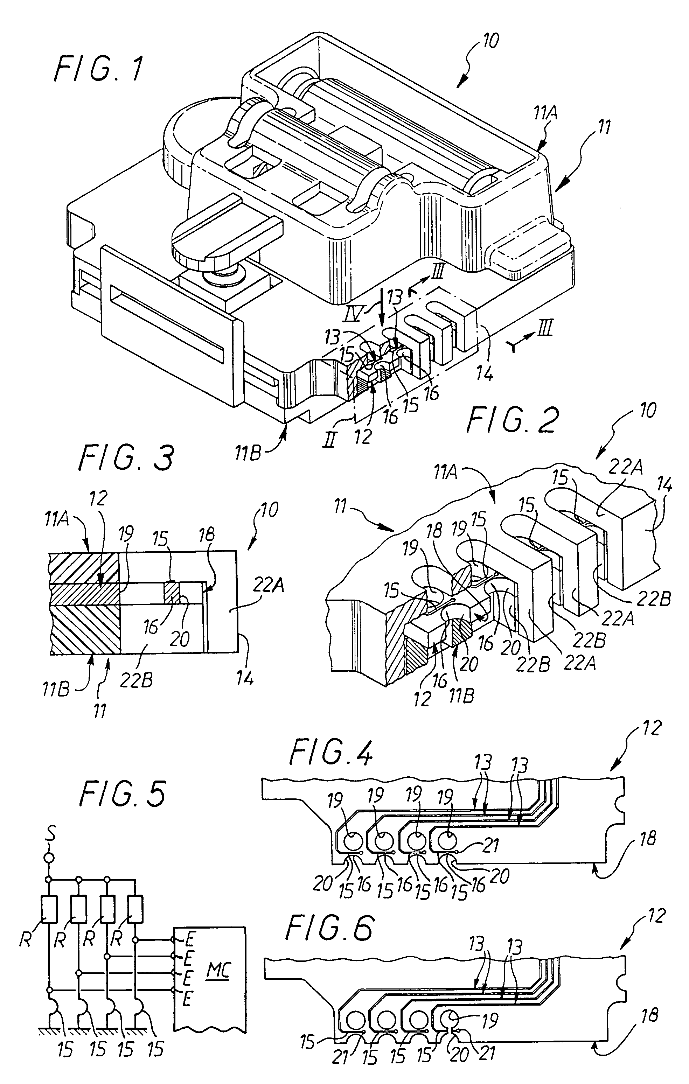

Sur la figure 1 se trouve représenté un quelconque dispositif de transmission 10.

Il peut s'agir aussi bien d'un émetteur que d'un récepteur.

Ce dispositif de transmission 10 ne relevant pas de la présente invention, il ne sera pas décrit dans tous ses détails ici.

Seuls en seront mentionnés, et éventuellement décrits, les éléments nécessaires à la compréhension de l'invention.

Il convient notamment d'indiquer à ce sujet que, à titre d'exemple, ce dispositif de transmission 10 est apte à communiquer par ondes électromagnétiques avec un autre dispositif de transmission de même type non représenté, et que, pour son appariement avec cet autre dispositif de transmission, il est équipé de moyens propres au respect d'un code entre eux.

Il convient, également, d'indiquer, que, dans la forme de réalisation représentée, le dispositif de transmission 10 comporte, en son sein, c'est-à-dire au sein d'un boîtier 11 qui en forme l'enveloppe extérieure, pour le support ou la desserte d'un ou plusieurs composants non visibles sur les figures, une plaquette de circuit imprimé 12, qui, sur l'une et/ou l'autre de ses faces supérieure et inférieure, voire même dans son épaisseur s'il s'agit d'une plaquette de circuit imprimé multicouche, est porteuse d'au moins une piste conductrice 13, et, en pratique, de plusieurs de telles pistes conductrices 13.

Dans la forme de réalisation représentée, le boîtier 11 est formé de deux coques 11A, 11B, l'une supérieure, l'autre inférieure, qui sont dûment solidarisées l'une à l'autre, par exemple par encliquetage, en étant par exemple articulées l'une à l'autre en portefeuille, et entre lesquelles la plaquette de circuit imprimé 12 est prise en sandwich.

Par exemple, et tel que représenté, la coque 11A supérieure, comporte, sur une partie au moins de son pourtour, un bord tombé 14 par lequel elle recouvre, conjointement, d'une part, la tranche de la plaquette de circuit imprimé 12, et, d'autre part, la tranche de la coque 11B inférieure.

Suivant l'invention, pour permettre le codage d'accord du dispositif de transmission 10 avec un autre, il est prévu, à la disposition de l'usager, dans ce dispositif de transmission 10, au moins un trajet conducteur sécable 15 dont dépend le code auquel répond ce dispositif de transmission 10.

Par exemple, et suivant des dispositions qui, relevant de l'homme de l'art, ne seront pas décrites en détail ici, ce trajet conducteur sécable 15 insère, sur les moyens de codage correspondants, au moins un quelconque autre composant, non visible sur les figures, de nature à modifier globalement les caractéristiques de ces moyens de codage.

Plus précisément, ce composant peut par exemple être apte à modifier la fréquence des ondes électromagnétiques en cause ou la nature du télégramme de communication.

Il peut s'agir, par exemple, d'un condensateur, d'une self, ou d'une résistance.

Un tel composant peut indifféremment être constitué d'un élément discret rapporté sur la plaquette de circuit imprimé 12 ou faire partie du circuit imprimé porté par celle-ci.

A titre indicatif, il a été supposé, sur la figure 5, qu'il s'agissait d'une résistance R insérée en série avec le trajet conducteur sécable 15 entre une source de tension continue S et la masse et que le point milieu entre cette résistance R et le trajet conducteur sécable 15 était relié à une entrée E d'un microprocesseur MC qui, appartenant au dispositif de transmission 10, pilote celui-ci.

Lorsque, comme en l'espèce, une telle plaquette de circuit imprimé 12 est présente, le trajet conducteur sécable 15 prévu suivant l'invention peut très simplement être constitué par un tronçon de l'une quelconque des pistes conductrices 13 que porte cette plaquette de circuit imprimé 12.

Pour ce faire, la plaquette de circuit imprimé 12 comporte au moins localement au moins une portion sécable 16, et la piste conductrice 13 concernée s'étend au moins localement sur cette portion sécable 16, en formant, au passage sur celle-ci, le trajet conducteur sécable 15 recherché.

Dans la forme de réalisation représentée, la portion sécable 16 de la plaquette de circuit imprimé 12 s'étend entre l'un des bords 18 de celle-ci et une ouverture 19 qui la traverse de part en part.

Plus précisément, elle s'étend entre l'ouverture 19 et une encoche 20 entaillant le bord 18 en question de la plaquette de circuit imprimé 12 au droit de l'ouverture 19.

Par exemple, et tel que représenté, l'ouverture 19 a un contour circulaire, et l'encoche 20 a elle-même un contour hémicirculaire, au même rayon que l'ouverture 19.

Cette ouverture 19 et cette encoche 20 sont ainsi faciles à réaliser.

Quoi qu'il en soit, en délimitant au mieux la portion sécable 16 qu'elles encadrent, elles facilitent l'accès à celle-ci et en rendent aisée la rupture lorsque cette rupture est recherchée.

Corollairement, dans la forme de réalisation représentée, la piste conductrice 13 formant le trajet conducteur sécable 15 s'étend parallèlement au bord 18 concerné de la plaquette de circuit imprimé 12, au moins au passage de la portion sécable 16 de celle-ci.

Plus précisément, dans cette forme de réalisation, cette piste conductrice 13 est issue d'un trou métallisé 21, qui la fait communiquer avec une autre partie, non visible sur les figures, du circuit imprimé porté par la plaquette de circuit imprimé 12, et qui se situe à l'une des extrémités de la portion sécable 16, et elle contourne l'ouverture 19 avant de s'étendre à nouveau parallèlement au bord 18 de la plaquette de circuit imprimé 12.

Mais, bien entendu, cette configuration n'est donnée ici qu'à titre d'exemple non limitatif, d'autres configurations pouvant être envisagées.

Préférentiellement, et cela est le cas dans la forme de réalisation représentée, le dispositif de transmission 10 suivant l'invention comporte, à la disposition de l'usager, plusieurs trajets conducteurs sécables 15.

Plus précisément, dans cette forme de réalisation, la plaquette de circuit imprimé 12 comporte, côte à côte, le long de son bord 18, plusieurs portions sécables 16 sur chacune desquelles s'étend au moins une piste conductrice 13 distincte.

Par exemple, et tel que représenté, quatre portions sécables 16 sont ainsi prévues côte à côte, à un pas régulier, sur la plaquette de circuit imprimé 12, et sur chacune d'elles ne s'étend qu'une piste conductrice 13, en y formant au passage un trajet conducteur sécable 15.

Toutes ces portions sécables 16 sont identiques, chacune d'elles s'étendant entre une ouverture 19 de la plaquette de circuit imprimé 12 et une encoche 20 de celle-ci, et les trajets conducteurs sécables 15 qu'elles portent sont alignés les uns avec les autres.

Préférentiellement, et cela est le cas dans la forme de réalisation représentée, chacun des trajets conducteurs sécables 15 que comporte ainsi le dispositif de transmission 10 suivant l'invention est accessible à l'usager de l'extérieur même du boîtier 11 de ce dispositif de transmission 10, sans qu'il soit nécessaire d'ouvrir ce boîtier 11.

Pour ce faire, l'une au moins des coques 11A, 11B constitutives de ce boîtier 11 comporte, localement, pour chacune des portions sécables 16 de la plaquette de circuit imprimé 12, un évidement 22A, 22B donnant accès à cette portion sécable 16.

Dans la forme de réalisation représentée, les portions sécables 16 de la plaquette de circuit imprimé 12 s'étendent en bordure des deux coques 11A, 11B, et, pour chacune d'elles, ces deux coques 11A, 11B comportent chacune, en correspondance l'une avec l'autre, un évidement 22A, 22B formant en pratique pour elles une encoche.

Les évidements 22A que comporte ainsi la coque 11A supérieure se prolongent en continu sur son bord tombé 14.

Préférentiellement, et tel que représenté, les flancs de chacun des évidements 22A, 22B des coques 11A, 11B sont parallèles entre eux et s'étendent perpendiculairement au trajet conducteur sécable 15 qu'ils encadrent.

Ils sont ainsi avantageusement à même de guider au mieux l'outil mis en oeuvre pour sectionner la portion sécable 16 concernée de la plaquette de circuit imprimé 12.

Sur la figure 6, seul un trajet conducteur sécable 15 a été supposé rompu, par rupture de la portion sécable 16 correspondante de la plaquette de circuit imprimé 12, mais il va de soi que, suivant le codage d'accord à réaliser, un ou plusieurs des autres trajets conducteurs sécables 15 peuvent également être rompus.

Lorsqu'un trajet conducteur sécable 15 est ainsi rompu, l'entrée E correspondante du microprocesseur MC n'est plus reliée à la masse, mais, à travers la résistance R associée, à la source de tension continue S, qui, en pratique, est de l'ordre de quelques volts.

Selon que les diverses entrées E concernées de ce microprocesseur MC sont ainsi à un potentiel nul ou à un potentiel non nul, elles définissent des niveaux logiques 1,0 dont il résulte l'établissement, par ce microprocesseur MC, d'un code déterminé.

Avec n trajets conducteurs sécables 15 suivant l'invention, il est avantageusement possible d'obtenir, par des combinaisons entre ces trajets conducteurs sécables 15, un nombre de codes différents largement supérieur à n.

Bien entendu, la présente invention ne se limite pas à la forme de réalisation décrite et représentée, mais englobe toute variante d'exécution.

En particulier, la communication entre les dispositifs de transmission à apparier ne se fait pas nécessairement par ondes électromagnétiques.

En outre, lorsqu'une plaquette de circuit imprimé est présente, une même portion sécable de celle-ci peut porter plusieurs pistes conductrices, et, donc, plusieurs trajets conducteurs sécables.

Enfin, au lieu d'être ainsi formé par un tronçon d'une piste conductrice sur une plaquette de circuit imprimé, un trajet conducteur sécable suivant l'invention peut tout aussi bien appartenir à un conducteur électrique classique, nu ou isolé.

## Revendications

1. Procédé pour permettre le codage d'accord d'un dispositif de transmission avec un autre, **caractérisé en ce qu'**il consiste à prévoir, à la disposition de l'usager, dans ce dispositif de transmission (10), au moins un trajet conducteur sécable (15) dont dépend le code auquel répond ce dispositif de transmission (10).

2. Procédé suivant la revendication 1, **caractérisé en ce que**, le dispositif de transmission (10) comportant une plaquette de circuit imprimé (12) porteuse d'au moins une piste conductrice (13), on choisit pour trajet conducteur sécable (15) un tronçon de cette piste conductrice (13), et, pour ce faire, on fait s'étendre au moins localement cette piste conductrice (13) sur une portion sécable (16) de la plaquette de circuit imprimé (12).

3. Procédé suivant la revendication 2, **caractérisé en ce qu'**on ménage la portion sécable (16) de la plaquette de circuit imprimé (12) entre l'un des bords (18) de celle-ci et une ouverture (19) qui la traverse de part en part.

4. Dispositif de transmission, **caractérisé en ce que**, en application d'un procédé conforme à l'une quelconque des revendications 1 à 3, il comporte, à la disposition de l'usager, au moins un trajet conducteur sécable (15) dont dépend le code auquel il répond.

5. Dispositif de transmission suivant la revendication 4 et comportant une plaquette de circuit imprimé (12) porteuse d'au moins une piste conductrice (13), **caractérisé en ce que** le trajet conducteur sécable (15) est constitué par un tronçon de cette piste conductrice (13), la plaquette de circuit imprimé (12) comportant localement au moins une portion sécable (16) sur laquelle s'étend au moins localement au moins une telle piste conductrice (13).

6. Dispositif de transmission suivant la revendication 5, **caractérisé en ce que** la portion sécable (16) de la plaquette de circuit imprimé (12) s'étend entre l'un des bords (18) de celle-ci et une ouverture (19) qui la traverse de part en part.

7. Dispositif de transmission suivant la revendication 6, **caractérisé en ce que**, au moins au passage de la portion sécable (16) de la plaquette de circuit imprimé (12), la piste conductrice (13) formant le trajet conducteur sécable (15) s'étend parallèlement au bord (18) correspondant de cette plaquette de circuit imprimé (12).

8. Dispositif de transmission suivant l'une quelconque des revendications 6, 7, **caractérisé en ce que** l'ouverture (19) de la plaquette de circuit imprimé (12) a un contour circulaire.

9. Dispositif de transmission suivant l'une quelconque des revendications 5 à 8, **caractérisé en ce que** la portion sécable (16) de la plaquette de circuit imprimé (12) s'étend entre l'ouverture (19) de celle-ci et une encoche (20) entaillant son bord (18).

10. Dispositif de transmission suivant la revendication 9, **caractérisé en ce que** l'encoche (20) de la plaquette de circuit imprimé (12) a un contour hémicirculaire.

11. Dispositif de transmission suivant l'une quelconque des revendications 4 à 10 et comportant un boîtier (11), **caractérisé en ce que** le trajet conducteur sécable (15) est accessible à l'usager de l'extérieur même du boîtier (11).

12. Dispositif de transmission suivant les revendications 5 et 11, prises conjointement, **caractérisé en ce que**, le boîtier (11) étant formé de deux coques (11A, 11B) entre lesquelles la plaquette de circuit imprimé (12) est prise en sandwich, l'une au moins de ces coques (11A, 11B) comporte localement un évidement (22A, 22B) donnant accès à la portion sécable (16) de cette plaquette de circuit imprimé (12).

13. Dispositif de transmission suivant la revendication 12, **caractérisé en ce que** la portion sécable (16) de la plaquette de circuit imprimé (12) s'étend en bordure des deux coques (11A, 11B), et celles-ci comportent chacune, en correspondance l'une avec l'autre, un évidement (22A, 22B) formant pour elles une encoche.

14. Dispositif de transmission suivant l'une quelconque des revendications 12, 13, **caractérisé en ce que** les flancs de l'évidement (22A, 22B) d'une coque (11A, 11B) sont parallèles entre eux et s'étendent perpendiculairement au trajet conducteur sécable (15).

15. Dispositif de transmission suivant l'une quelconque des revendications 4 à 14, **caractérisé en ce qu'**il comporte plusieurs trajets conducteurs sécables (15).

16. Dispositif de transmission suivant les revendications 5 et 15, prises conjointement, **caractérisé en ce que** la plaquette de circuit imprimé (12) comporte côte à côte plusieurs portions sécables (16) sur chacune desquelles s'étend au moins une piste conductrice (13) distincte.

## Patentansprüche

1. Kodierungsverfahren zur Abstimmung einer Übertragungsvorrichtung auf eine andere, **dadurch gekennzeichnet, dass** in dieser Übertragungsvorrichtung (10) mindestens eine dem Benutzer zur Verfügung stehende durchtrennbare leitende Strecke (15) vorgesehen wird, von welcher der Kode abhängt, dem diese Übertragungsvorrichtung (10) entspricht.

2. Verfahren nach Anspruch 1, **dadurch gekennzeichnet, dass** man, wenn die Übertragungsvorrichtung (10) eine gedruckte Schaltungsplatte (12) aufweist, die mindestens eine leitende Bahn (13) trägt, als durchtrennbare leitende Strecke (15) einen Abschnitt dieser leitenden Bahn (13) wählt, und man zu diesem Zweck diese leitende Bahn (13) sich mindestens örtlich auf einem durchtrennbaren Bereich (16) der gedruckten Schaltungsplatte (12) erstrecken lässt.

3. Verfahren nach Anspruch 2, **dadurch gekennzeichnet, dass** man den durchtrennbaren Bereich (16) der gedruckten Schaltungsplatte (12) zwischen einem ihrer Ränder (18) und einer sie vollständig durchquerenden Öffnung (19) vorsieht.

4. Übertragungsvorrichtung, **dadurch gekennzeichnet, dass** sie in Anwendung eines Verfahrens nach einem der Ansprüche 1 bis 3 mindestens eine dem Benutzer zur Verfügung stehende durchtrennbare leitende Strecke (15) aufweist, von der der Kode abhängt, dem sie entspricht.

5. Übertragungsvorrichtung nach Anspruch 4 mit einer mindestens eine leitende Bahn (13) tragenden gedruckten Schaltungsplatte (12), **dadurch gekennzeichnet, dass** die durchtrennbare leitende Strecke (15) aus einem Abschnitt dieser leitenden Bahn (13) besteht, wobei die gedruckte Schaltungsplatte (12) örtlich mindestens einen durchtrennbaren Bereich (16) besitzt, auf dem sich mindestens örtlich mindestens eine solche leitende Bahn (13) erstreckt.

6. Übertragungsvorrichtung nach Anspruch 5, **dadurch gekennzeichnet, dass** der durchtrennbare Bereich (16) der gedruckten Schaltungsplatte (12) sich zwischen einem ihrer Ränder (18) und einer sie vollständig durchquerenden Öffnung (19) erstreckt.

7. Übertragungsvorrichtung nach Anspruch 6, **dadurch gekennzeichnet, dass** sich die die durchtrennbare leitende Strecke (15) bildende leitende Bahn (13) mindestens bei Durchgang durch den durchtrennbaren Bereich (16) der gedruckten Schaltungsplatte (12) parallel zu dem entsprechenden Rand (18) dieser gedruckten Schaltungsplatte (12) erstreckt.

8. Übertragungsvorrichtung nach einem der Ansprüche 6, 7,
**dadurch gekennzeichnet, dass** die Öffnung (19) der gedruckten Schaltungsplatte (12) einen kreisförmigen Umriss besitzt.

9. Ubertragungsvorrichtung nach einem der Ansprüche 5 bis 8, **dadurch gekennzeichnet, dass** sich der durchtrennbare Bereich (16) der gedruckten Schaltungsplatte (12) zwischen deren Öffnung (19) und einer in ihren Rand (18) einschneidenden Einkerbung (20) erstreckt.

10. Übertragungsvorrichtung nach Anspruch 9, **dadurch gekennzeichnet, dass** die Einkerbung (20) der gedruckten Schaltungsplatte (12) einen halbkreisförmigen Umriss aufweist.

11. Übertragungsvorrichtung nach einem der Ansprüche 4 bis 10 mit einem Gehäuse (11), **dadurch gekennzeichnet, dass** die durchtrennbare leitende Strecke (15) für den Benutzer von außerhalb des Gehäuses (11) zugänglich ist.

12. Übertragungsvorrichtung nach den Ansprüchen 5 und 11 zusammen, **dadurch gekennzeichnet, dass** das Gehäuse (11) von zwei Schalen (11A, 11B) gebildet ist, zwischen denen die gedruckte Schaltungsplatte (12) sandwichartig eingeschlossen ist, und dass mindestens eine dieser Schalen (11A, 11B) ortlich eine Aussparung (22A, 22B) aufweist, die den durchtrennbaren Bereich (16) dieser gedruckten Schaltungsplatte (12) zugänglich macht.

13. Übertragungsvorrichtung nach Anspruch 12, **dadurch gekennzeichnet, dass** der durchtrennbare Bereich (16) der gedruckten Leitungsplatte (12) sich am Rand der beiden Schalen (11A, 11B) erstreckt und diese jeweils in Entsprechung miteinander eine Aussparung (22A, 22B) aufweisen, die für diese eine Einkerbung bildet.

14. Übertragungsvorrichtung nach einem der Ansprüche 12, 13, **dadurch gekennzeichnet, dass** die Flanken der Aussparung (22A, 22B) einer Schale (11A, 11B) zueinander parallel sind und sich senkrecht zur durchtrennbaren leitenden Strecke (15) erstrecken.

15. Übertragungsvorrichtung nach einem der Ansprüche 4 bis 14, **dadurch gekennzeichnet, dass** sie mehrere durchtrennbare leitende Strecken (15) aufweist,

16. Übertragungsvorrichtung nach den Ansprüchen 5 und 15 zusammen, **dadurch gekennzeichnet, dass** die gedruckte Schaltungsplatte (12) nebeneinander mehrere durchtrennbare Bereiche (16) aufweist, auf deren jedem sich mindestens eine einzelne leitende Bahn (13) erstreckt.

## Claims

1. Method to allow conformity coding of one transmission device with another, **characterised in that** it consists of providing, for employment by the user, in said transmission device (10), at least one severable conductive path (15) upon which the code to which said transmission device (10) responds depends.

2. Method according to claim 1, **characterised in that** as the transmission device (10) comprises a printed circuit board (12) carrying at least one conductive track (13), a portion of said conductive track (13) is selected as the severable conductive path (15), and in order to implement this, said conductive track (13) is at least locally extended over a severable portion (16) of the printed circuit board (12).

3. Method according to claim 2, **characterised in that** the severable portion (16) of the printed circuit board (12) is arranged between one of the edges (18) thereof and an aperture (19) which passes right through it.

4. Transmission device, **characterised in that** by application of a method according to any one of claims 1 to 3, it comprises, for employment by the user, at least one severable conductive path (15) upon which the code to which it responds depends.

5. Transmission device according to claim 4 and comprising a printed circuit board (12) carrying at least one conductive track (13), **characterised in that** the severable conductive path (15) is constituted by a portion of said conductive track (13), the printed circuit board (12) locally comprising at least one severable portion (16) on which there extends at least locally at least one such conductive track (13).

6. Transmission device according to claim 5, **characterised in that** the severable portion (16) of the printed circuit board (12) extends between one of the edges (18) thereof, and an aperture (19) which passes right through it.

7. Transmission device according to claim 6, **characterised in that** at least in passing through the severable portion (16) of the printed circuit board (12), the conductive track (13) forming the severable conductive path (15) extends parallel to the corresponding edge (18) of said printed circuit board (12).

8. Transmission device according to any one of claims 6, 7 **characterised in that** the aperture (19) of the printed circuit board (12) has a circular contour.

9. Transmission device according to any one of claims 5 to 8, **characterised in that** the severable portion (16) of the printed circuit board (12) extends between the aperture (19) thereof and a notch (20) nicking its edge (18).

10. Transmission device according to claim 9, **characterised in that** the notch (20) of the printed circuit board (12) has a semi-circular contour.

11. Transmission device according to any one of claims 4 to 10 and comprising a casing (11), **characterised in that** the severable conductive path (15) is accessible to the user even from the exterior of the casing (11).

12. Transmission device according to claims 5 and 11 taken together, **characterised in that** the casing (11) being formed from two shells (11A, 11B) between which the printed circuit board (12) is sandwiched, at least one of said shells (11A, 11B) comprises locally a recess (22A, 22B) providing access to the severable portion (16) of said printed circuit board (12).

13. Transmission device according to claim 12, **characterised in that** the severable portion (16) of the printed circuit board (12) extends along the edge of the two shells (11A, 11B), and said shells each comprise a recess (22A, 22B) corresponding one with the other, forming a notch for themselves.

14. Transmission device according to any one claims 12, 13, **characterised in that** the flanks of the recess (22A, 22B) of one shell (11A, 11B) are mutually parallel and extend perpendicular to the severable conductive path (15).

15. Transmission device according to any one of claims 4 to 14, **characterised in that** it comprises several severable conductive paths (15).

16. Transmission device according to claims 5 and 15, **characterised in that** the printed circuit board (12) comprises, side by side, several severable portions (16) on each of which there extends at least one distinct conductive track (13).
